# EUROPÄISCHE PATENTSCHRIFT

(11) **EP 3 970 458 B1**
(45) Veröffentlichungstag und Bekanntmachung des Hinweises auf die Patenterteilung: **31.07.2024**
(21) Anmeldenummer: 20724792.5
(22) Anmeldetag: 05.05.2020
(51) Int. Cl.: H05K 5/00, H01H 9/04, H02B 1/28

(54) **BAUKASTENSYSTEM ZUM HERSTELLEN EINES GEHÄUSES**
MODULAR SYSTEM FOR PRODUCING A HOUSING
SYSTÈME MODULAIRE POUR LA PRODUCTION D'UN ENCASTREMENT

(30) Priorität: 17.05.2019 DE 102019113193
(43) Veröffentlichungstag der Anmeldung: 23.03.2022
(73) Patentinhaber: R. STAHL Schaltgeräte GmbH, 74638 Waldenburg (DE)
(72) Erfinder: ARNHOLD, Thorsten, 74629 Pfedelbach (DE)
(74) Vertreter: Rüger Abel Patentanwälte PartGmbB
(86) Internationale Anmeldenummer: PCT/EP2020/062466
(87) Internationale Veröffentlichungsnummer: WO 2020/233983

(56) Entgegenhaltungen:
- CN-A- 110 831 671
- DE-A1- 102011 001 723
- DE-A1- 102017 112 147
- DE-U1- 202004 019 510
- US-A1- 2010 265 744
- US-B2- 8 987 592

## Beschreibung

Die Erfindung betrifft das Gebiet explosionsgeschützter Gehäuse.

Explosionsgeschützte Gehäuse können insbesondere nach der Schutzart druckfeste Kapselung ausgebildet sein. Diese verhindert, dass eine durch ein Betriebsmittel innerhalb des Gehäuses gezündete Explosion nach außen dringt und die Atmosphäre um das Gehäuse entzündet. Dazu kann eine Öffnung des Gehäuses mit einem Flammenschutzfilter verschlossen werden. Beispiele solcher Flammenschutzfilter gehen aus der DE 10 2014 116 149 A1 hervor. Der Flammenschutzfilter kann mit dem Öffnungsrand beispielsweise verschweißt oder anderweitig stoffschlüssig verbunden werden, wie aus DE 10 2017 112 149 A1 und DE 10 2017 122 957 A1 hervorgeht. DE 10 2017 112 147 A1 beschreibt einen in eine Gehäusewand eingegossenen Druckentlastungskörper. Außerdem wird in der US 2010/265744 A1 ein Gehäuse beschrieben, in dem Leistungshalbleitereinheiten mit zugeordneten Kühlplatten untergebracht sind, wobei die Kühlplatten einen Teil des Gehäuses bilden. Ferner offenbart die DE 10 2011 01723 A1 ein druckfestes Gehäuse, das aus zwei Blechzuschnitten besteht, die u-förmig abgekantet sind und bei der Herstellung ineinander gefügt, geheftet und anschließend ohne Schweißnahtvorbereitung durch eine umlaufende Kehlnaht zusammengeschweißt werden. Die DE 20 2004 019510 U1 beschreibt einen Brandschutzschrank mit einer Umkleidung aus einer Deckwand, zwei Seitenwänden, einer Bodenwand, einer Rückwand und einer Tür, wobei diese Umkleidungselemente jeweils einen brandschutzsicheren Wandaufbau aus mehreren Schichten aufweisen.

Es ist Aufgabe der Erfindung, ein Konzept anzugeben, mittels welchem ein explosionsgeschütztes Gehäuse einfach und kostengünstig herstellbar ist.

Diese Aufgabe wird mit einem explosionsgeschützten Gehäuse, einem Modul für ein explosionsgeschütztes Gehäuse, ein Baukastensystem zur Herstellung eines explosionsgeschützten Gehäuses sowie ein Verfahren zur Fertigung eines explosionsgeschützten Gehäuses gelöst:

Das erfindungsgemäße explosionsgeschützte Gehäuse ist bevorzugt nach der Schutzart druckfeste Kapselung ausgebildet. Das Gehäuse kann insbesondere einer entsprechenden Norm genügen, beispielsweise der Norm IEC/EN 60079-1 (Explosionsschutzart Ex d) oder einer entsprechenden amerikanischen Norm.

Das Gehäuse weist wenigstens ein Modul eines Baukastensystems zur Herstellung des Gehäuses auf.

Ausführungsformen des Gehäuses weisen bevorzugt mehrere (wenigstens zwei) Wandmodule auf, welche auch als Segmente bezeichnet werden können. Bevorzugt werden gegossene Wandmodule. Alternativ oder zusätzlich können Blechteile, insbesondere umgeformte Blechteile, als Wandmodule verwendet werden oder aus umgeformten Blechteilen gebildete Wandmodule. Mischformen sind möglich, in denen ein Wandmodul aus wenigstens einem gegossenen Körper und wenigstens einem Blechteil gebildet ist. Das Blechteil kann beispielsweise eine Öffnung in dem gegossenen Körper zünddurchschlagsicher schließen.

Es wird außerdem ein erfindungsgemäßes Modul, beispielsweise ein, bevorzugt gegossenes, Wandmodul, für ein erfindungsgemäßes explosionsgeschütztes Gehäuse angegeben.
Erfindungsgemäß wird auch ein Baukastensystem zur Herstellung eines erfindungsgemäßen explosionsgeschützten Gehäuses mit wenigstens einer Sorte (Typ) Module angegeben. Ausführungsformen des erfindungsgemäßen Baukastensystems können ein flächiges Tragelement als Modul aufweisen. Ein Modul kann beispielsweise ein gegossenes oder aus Blech geformtes Wandmodul sein. Das Baukastensystem kann beispielsweise wenigsten eine Sorte längliche Tragelemente aufweisen, welche zu einem Rahmen anordnenbar sind. Ausführungsformen des Baukastensystems sind möglich, welche alternativ oder zusätzlich wenigstens ein rahmenförmiges Tragelement aufweisen, welches ein Modul des Baukastensystems bildet. Zumindest eine Sorte flächige oder längliche oder rahmenförmige Tragelemente kann einen Winkel bilden. Alternativ oder zusätzlich kann das Baukastensystem zumindest eine Sorte flächige oder rahmenförmige Tragelemente aufweisen, welche eben sein können.

Es wird zudem ein Verfahren zum Herstellen eines explosionsgeschützten Gehäuses angegeben. Zu dem Verfahren gehören die Schritte Bereitstellen von Modulen, beispielsweise gegossenen oder aus Blech geformten Wandmodulen, und Zusammensetzen des Gehäuses aus den Modulen, beispielsweise den Wandmodulen.

Weitere bevorzugte Merkmale und Ausführungsformen des Gehäuses, des Moduls, des Baukastensystems und/oder des Verfahrens ergeben sich aus der folgenden Beschreibung:

Ein Wandmodul kann eine Seitenwand, einen Deckel oder einen Boden bilden. Bevorzugt bildet ein oder bilden die Wandmodule Seitenwände.

Die Wandmodule können insbesondere einen Innenraum des Gehäuses in Umfangsrichtung bzw. seitlich umschließen. Der Gehäuseumfang ist bevorzugt mittels wenigstens zweier oder wenigstens dreier oder wenigstens vierer Wandmodule geschlossen. Unter den Wandmodulen, welche den Umfang schließen, sind bevorzugt wenigstens zwei oder wenigstens drei gleichartige (gleiche Sorte) Wandmodule. Die den Umfang des Innenraums umschließende Wandmodulen gehören vorzugsweise maximal drei Sorten an. Die Sorten werden vorzugsweise aufgrund ihrer unterschiedlichen, in Ausführungsformen gegossenen, Gestalt unterschieden.

Bevorzugt weist wenigstens ein Wandmodul des Gehäuses und/oder wenigstens eine Sorte Wandmodule eine Druckentlastungsöffnung auf. Diese kann mit einem Druckentlastungselement zünddurchschlagsicher verschlossen sein. Vorstehend zitierte Veröffentlichungen geben Beispiele für mögliche zünddurchschlagsichere Druckentlastungselemente (auch Flammenschutzfilter genannt) und deren Befestigung. Das Druckentlastungselement kann beispielsweise in das Wandmodul eingegossen sein. Zünddurchschlagsicher bedeutet, dass der Verschluss kein Gas oder Partikel passieren lässt, das so heiß ist, dass es eine explosionsfähige Atmosphäre außerhalb des Gehäuses entzünden könnte. In der Verbindungstelle vorhandene Spalte sind vielmehr so lang und zudem so eng, dass das Gas und Partikel beim Durchtreten durch die Spalte so weit abkühlen, dass das Gas und die Partikel die Atmosphäre nicht entzünden könnte. Das Druckentlastungselement lässt vorzugsweise einen Gasaustausch durch die Druckentlastungsöffnung zu, um beispielsweise bei einer Explosion für einen Druckausgleich zwischen dem Innenraum des Gehäuses und der äußeren Umgebung zu sorgen. Das Druckentlastungselement weist dazu offene Poren auf, die bevorzugt zünddurchschlagsichere Spalte bilden. Wenigstens ein anderes Wandmodul kann frei von einer Druckentlastungsöffnung sein.

Bevorzugt ist wenigstens eine Seite des Gehäuses durch ein plattenförmiges Element geschlossen. Das Element kann beispielsweise einen Boden oder einen Deckel des Gehäuses bilden, um die Unterseite oder die Oberseite des Gehäuses zu schließen.

Wenigstens ein Wandmodul weist bevorzugt eine Ausrichtstruktur auf, welche mit einer Gegenausrichtstruktur eines Elements, insbesondere plattenförmigen Elements, welche dem Schließen des Gehäuses dient, zur lagerichtigen Anordnung des Wandmoduls relativ zu dem Element zusammenarbeitet. Wenigstens ein Wandmodul weist bevorzugt wenigstens einen Vorsprung, z.B. einen Zapfen, und/oder eine Ausnehmung auf, der oder die zur lagerichtigen Anordnung des Wandmoduls bezüglich des Elements, insbesondere des plattenförmigen Elements, und/oder zur Verbindung des plattenförmigen Elements mit dem Wandmodul dient. In dem zusammengesetzten Gehäuse ist der Vorsprung vorzugsweise in einer Ausnehmung in dem Element angeordnet und/oder ein Vorsprung des Elements in einer Ausnehmung des Wandmoduls, wobei ersteres bevorzugt wird, wenn das Wandmodul gegossen ist.

Wenigstens ein Wandmodul weist bevorzugt einen Stabilisierungsfortsatz auf. Der Stabilisierungsfortsatz kann beispielsweise eine Rippe oder ein Steg oder ein Ausleger sein. Der Stabilisierungsfortsatz erstreckt sich von dem Wandmodul weg. Mit dem Stabilisierungsfortsatz kann das Wandmodul und/oder die Verbindung zwischen dem Wandmodul und dem Element stabilisiert werden. Der wenigstens eine Vorsprung kann an einem Stabilisierungsfortsatz ausgebildet, insbesondere angeformt, sein. Bevorzugt sind der Stabilisierungsfortsatz und vorzugsweise auch der Vorsprung an dem Wandmodul angeformt, insbesondere nahtlos einstückig mit dem Wandmodul verbunden. Wenn der Stabilisierungsfortsatz und ggf. auch der Vorsprung beim Gießvorgang des Wandmoduls mit geformt werden, entfällt ein nachträgliches befestigen des Stabilisierungsfortsatzes bzw. des Vorsprungs.

Das Element kann mit dem Wandmodul beispielsweise stoffschlüssig verbunden, insbesondere schweißverbunden und/oder klebeverbunden, sein. Beispielsweise ist der wenigstens eine Vorsprung mit dem Rand der Ausnehmung stoffschlussverbunden, insbesondere schweißverbunden und/oder klebeverbunden. Das Element kann mit dem Wandmodul insbesondere durch Lochschweißen durch Ausnehmungen für die Vorsprünge verbunden sein.

Die Wandmodule untereinander sind vorzugsweise stoffschlüssig verbunden. Die Wandmodule untereinander können insbesondere verschweißt und/oder verklebt sein.

Wenn das Gehäuse nach der Schutzart druckfeste Kapselung gekapselt ist, sind vorhandene Spalte, welche von dem Innenraum des Gehäuses prinzipiell nach außen führen können, zünddurchschlagssicher. Bevorzugt ist in der Anordnung zwischen den Wandmodulen und dem Element ein zünddurchschlagsicherer Spalt, insbesondere Flachspalt, festgelegt. Die Wandmodule bilden vorzugsweise mit dem Element, insbesondere plattenförmigen Element einen zünddurchschlagsicheren Spalt, insbesondere einen Flachspalt.

Die Wandmodule weisen vorzugsweise je einen Flanschabschnitt zur Befestigung eines weiteren Elements, insbesondere weiteren plattenförmigen Elements, auf. Das weitere Element kann beispielsweise den Deckel oder den Boden bilden. Der Flanschabschnitt ist vorzugsweise mit dem Wandmodul nahtlos einstückig verbunden. Bevorzugt wird entsteht der Flanschabschnitt bei einem Gießprozess zur Herstellung des Wandmoduls gleich mit.

Die Flanschabschnitte untereinander sind vorzugsweise stoffschlüssig verbunden, insbesondere verschweißt und/oder verklebt.

Die Anordnung der Flanschabschnitte kann nach dem Verbinden der Wandmodule untereinander plangefräst sein, um einen Flachspalt zwischen den Flanschabschnitten und dem Element auszubilden.

Das weitere Element kann an den Flanschabschnitten beispielsweise mittels einer Schraub-, Klemm-, Schweiß- und/oder Klebeverbindung oder einer sonstigen form-, kraft- und/oder stoffschlüssigen Verbindung befestigt werden.

Während das Gehäuse prinzipiell eine beliebige Form aufweisen kann, welche durch Anordnung der Wandmodule entsteht, ist das Gehäuse vorzugsweise ein Polyeder, insbesondere ein Prisma, beispielsweise ein Quader mit ungleichlangen Kanten oder ein Würfel.

Es werden Ausführungsformen bevorzugt, bei denen Seitenkanten des Gehäuses von Wandmodulen beinhaltet werden. Bevorzugt beinhaltet wenigstens eines der Wandmodule wenigstens eine oder nur eine Kante des Gehäuses zumindest abschnittsweise.

Bevorzugt werden wenigstens zwei Wandmodule nicht über eine oder an einer Seitenkante, d.h. gemeinsam, ggf. mit der Schweiß- und/oder Klebenaht, eine Kante bildend, aneinander befestigt. Vielmehr ist die Schweißnaht und/oder Klebenaht bevorzugt in Umfangsrichtung neben der Kante, insbesondere parallel zu der Kante, mit Abstand zu der Kante des Gehäuses ausgebildet. Die Schweiß- und/oder Klebenaht ist bevorzugt eine Dichtnaht, um auf die Sicherstellung eines zünddurchschlagsicheren Spalts in der Verbindung der Wandmodule verzichten zu können. Die Verbindung zwischen den Wandmodulen wird mit der Dichtnaht vollständig geschlossen.

Ein Wandmodul kann zwei zueinander abgewinkelte Wandabschnitte aufweisen, wobei die Länge eines Wandabschnitts bevorzugt echt größer ist als die Länge des zweiten Wandabschnitts. Die Wandabschnitte stoßen an einer Kante des Gehäuses gedacht zusammen. Diese Kante (Seitenkante) ist folglich durch ein einziges Wandmodul gebildet. Die Wandabschnitte sind bevorzugt nahtlos einstückig miteinander verbunden und besonders bevorzugt beim Gießherstellungsprozess des Wandmoduls zusammen hergestellt.

Zwei Wandmodule können insbesondere mit einem Stumpfstoß oder einer Stumpfnaht miteinander verschweißt und/oder verklebt sein. Die Wandmodule können quer, insbesondere senkrecht zueinander, orientiert sein.

Das Baukastensystem kann beispielsweise wenigstens eine, wenigstens zwei oder nur zwei oder wenigstens drei oder nur drei unterschiedliche Sorten Seitenwandmodule zum Umschließen des Innenraums in Gehäuseumfangsrichtung aufweisen. Die Sorten Wandmodule können beispielsweise nach der Größe, Form und/oder Ausstattung unterschieden werden. Insbesondere können die Sorten Wandmodule beispielsweise nach der gegossenen Größe oder gegossenen Form unterschieden werden. Manche Sorten Wandmodule, z.B. eine Sorte Wandmodule oder zwei Sorten Wandmodule können mit Druckentlastungsöffnungen ausgestattet sein, während eine weitere Sorte Wandmodule beispielsweise keine Druckentlastungsöffnung aufweist, also frei von Druckentlastungsöffnungen ist.

In dem erfindungsgemäßen Baukastensystem kann genau eine Sorte oder genau zwei Sorten Wandmodule mit je wenigstens einer oder genau einer vertikalen Seitenkante des Gehäuses aufweisen und/oder eine oder genau eine Sorte Wandmodule, welche frei von einer vertikalen Seitenkante des Gehäuses sind.

In Ausführungsformen kann ein Modul einen rahmenförmigen Grundkörper aufweisen, der wenigstens eine Öffnung umgrenzt, welche mittels wenigstens eines Blechteils zünddurchschlagsicher verschlossen ist.

Weitere vorteilhafte Merkmale der Erfindung ergeben sich aus den Unteransprüchen, der nachfolgenden Beschreibung sowie den Zeichnungen. Es zeigen:
Figur 1 - ein Ausführungsbeispiel eines erfindungsgemäßen Gehäuses,
Figur 2a - beispielhaft eine perspektivische Ansicht einer Anordnung von vier Wandmodulen und einem Bodenelement für das Gehäuse gemäß Figur 1,
Figur 2b - eine Explosionsansicht der Anordnung gemäß Figur 2a,
Figur 2c - perspektivisch die Gehäuseanordnung gemäß Figuren 2a und 2b von der Unterseite,
Figur 2d - perspektivisch die Anordnung gemäß Figuren 2a bis 2c nach weiteren Fertigungsschritten,
Figur 3a - eine erste Sorte Wandmodule eines Ausführungsbeispiels eines Baukastensystems in einer perspektivischen Ansicht,
Figur 3b - das Wandmodul der ersten Sorte gemäß Figur 3a in einer Ansicht auf die Innenseite des Wandmoduls,
Figur 3c - einen Schnitt durch das Wandmodul gemäß Figur 3b,
Figur 3d - eine Ansicht auf die Unterseite des Wandmoduls gemäß Figur 3a,
Figur 4a - eine zweite Sorte Wandmodule des Baukastensystems in einer perspektivischen Ansicht,
Figur 4b - das Wandmodul der zweiten Sorte gemäß Figur 4a in einer Ansicht auf die Innenseite des Wandmoduls,
Figur 4c - eine weitere Ansicht des Wandmoduls der zweiten Sorte gemäß Figur 4a bis 4b,
Figur 4d - eine Ansicht auf die Unterseite des Wandmoduls gemäß Figur 4a,
Figur 5a - eine dritte Art Wandmodul eines Baukastensystems in einer perspektivischen Ansicht,
Figur 5b - das Wandmodul der zweiten Sorte gemäß Figur 5a in einer Ansicht auf die Innenseite des Wandmoduls,
Figur 5c - einen Schnitt durch das Wandmodul gemäß Figur 5b,
Figur 5d - eine Ansicht auf die Unterseite des Wandmoduls gemäß Figur 5a,
Figur 6a - beispielhaft eine weitere Anordnung von Wandmodulen des Baukastensystems zu einem erfindungsgemäßen Gehäuse,
Figur 6b - beispielhaft noch eine weitere Anordnung von Wandmodulen des Baukastensystems für ein erfindungsgemäßes Gehäuse,
Figur 7a - einen Grundkörper eines weiteren Ausführungsbeispiels eines erfindungsgemäßen Baukastensystems,
Figur 7b - ein Schließelement zum Schließen von Öffnungen in dem Grundkörper,
Figur 7c - ein weiteres Ausführungsbeispiel eines Schließelements zum Schließen von Öffnungen in dem Grundkörper,
Figur 8 - ein Beispiel eines Gehäuses aus Wandmodulen und
Figur 9 - ein weiteres Ausführungsbeispiel eines Gehäuses zusammengesetzt aus Wandmodulen.

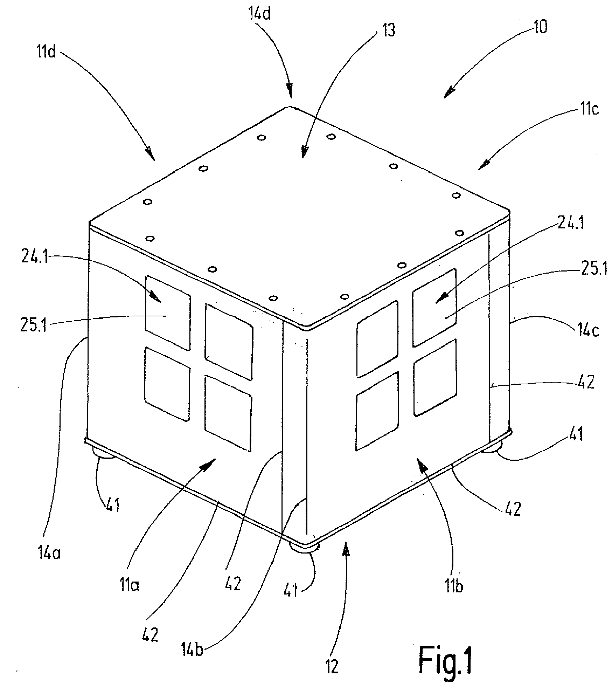

Figur 1 zeigt ein Ausführungsbeispiel eines erfindungsgemäßen Gehäuses 10. Das Gehäuse 10 weist vier vertikale Umfangsseiten 11a-d auf. Das Gehäuse 10 weist einen Boden 12 und einen Deckel 13 auf. Das dargestellte Ausführungsbeispiel des Gehäuses 10 ist quaderförmig mit ungleichlangen Kanten oder würfelförmig. Das Gehäuse 10 weist vier parallele vertikale Seitenkanten 14a-d auf.

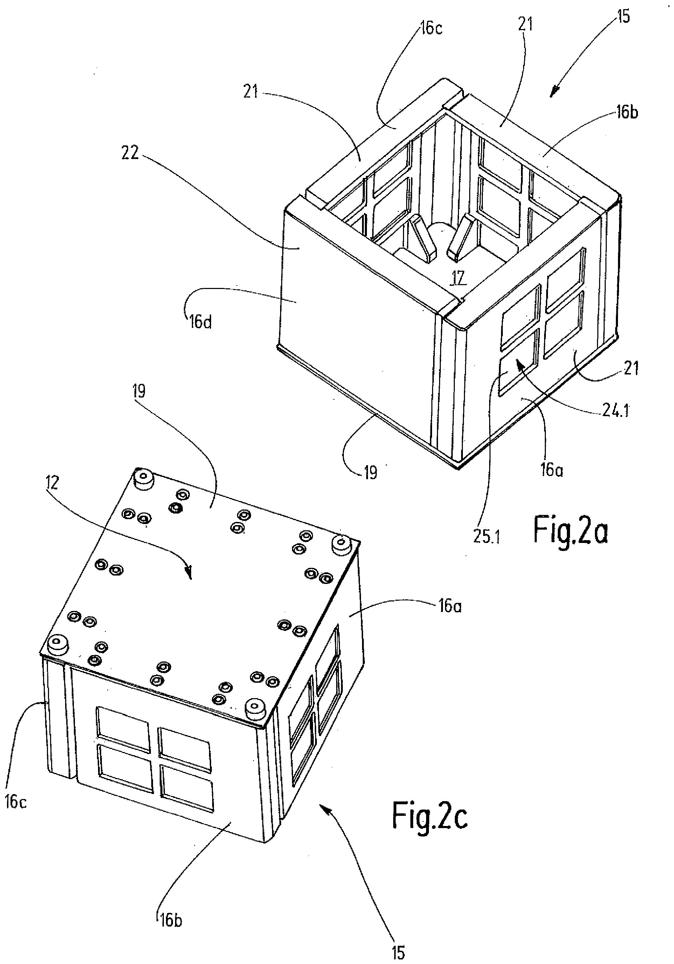

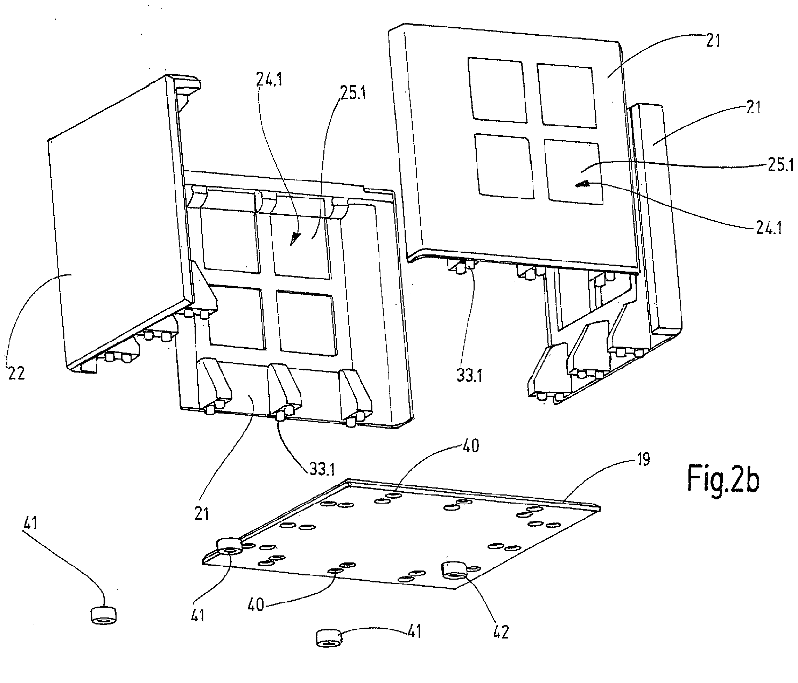

Die Figuren 2a-2d zeigen ein Ausführungsbeispiel einer Anordnung 15 von erfindungsgemäßen vier Wandmodulen 16a-d aus denen das Gehäuse 10 gemäß Figur 1 aufgebaut ist.

Die Anordnung 15 gemäß Figuren 2a-2d ist aus vier gegossenen Wandmodulen 16a-d zusammengesetzt, die den Innenraum 17 des Gehäuses 10 in Umfangsrichtung bzw. seitlich umschließen. Die Umfangsrichtung ist in einer horizontalen Ebene festgelegt. Die gegossenen Wandmodule 16a-d bilden die vertikalen Umfangsseitenwände des Gehäuses 10. Grundsätzlich können die Wandmodule 16a-d oder einzelne Wandmodule auch aus Blech gefertigt, insbesondere gepresst sein. Der Boden 12 ist durch ein plattenförmiges Element 19 gebildet. Der Deckel 13 (in Figur 2a-d nicht gezeigt) ist ebenfalls durch ein plattenförmiges Element 20 gebildet.

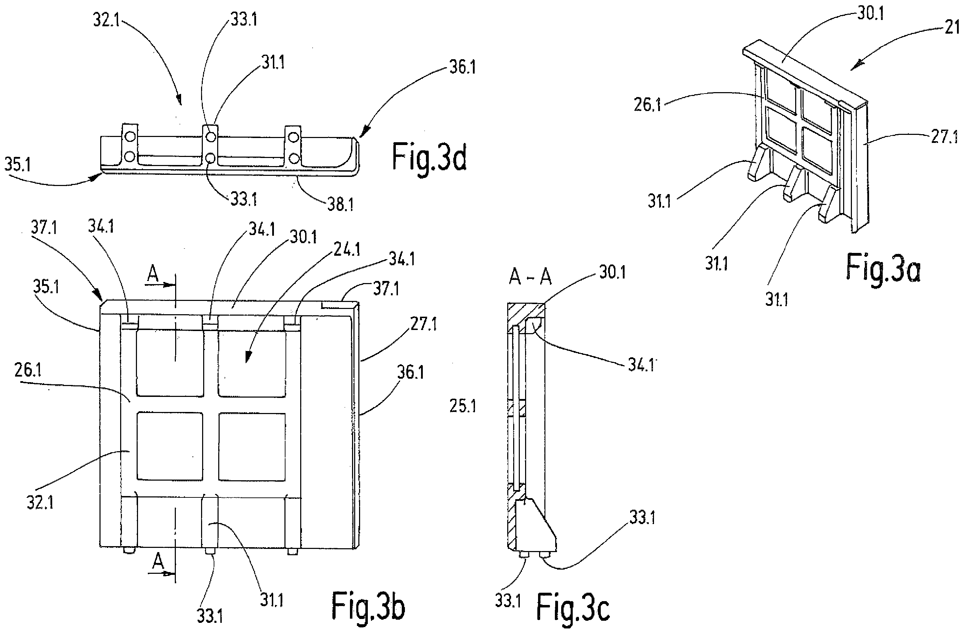

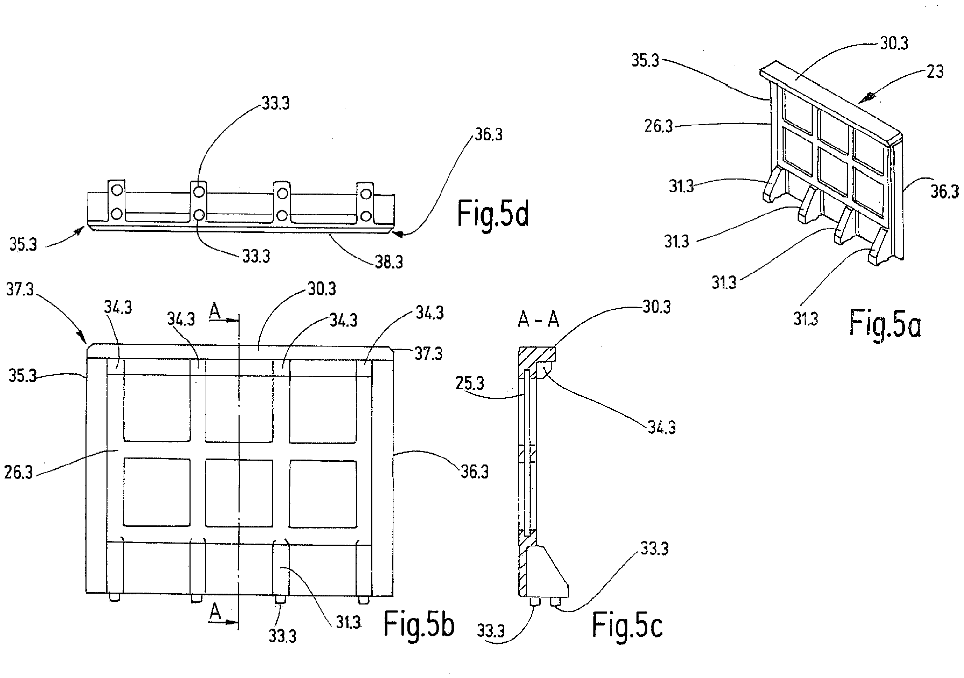

Das Gehäuse 10 ist aus zwei unterschiedlichen Sorten 21, 22 Wandmodulen eines Baukastensystems zusammengesetzt. Eine erste Sorte 21 Wandmodule des Baukastensystems zeichnet sich durch das Aufweisen von Druckentlastungsöffnungen 24.1 (z.B. wie gezeigt vier Druckentlastungsöffnungen 24.1 oder im Falle der dritten Sorte 23 Wandmodule gemäß Figuren 5a bis 5d beispielsweise sechs Druckentlastungsöffnungen 24.3) und die Abmessung des Wandmoduls der Sorte 21 aus. Diese Sorte 21 Wandmodule ist in den Figuren 3a bis 3d gesondert dargestellt. Die Druckentlastungsöffnungen 24.1 sind jeweils mit einem oder mehreren gasdurchlässigen Druckentlastungselementen 25.1 zünddurchschlagsicher verschlossen.

Drei gleiche Wandmodule 16a-c, d.h. drei Exemplare der ersten Sorte 21 Wandmodule des Baukastensystems, sind aneinander angrenzend angeordnet.

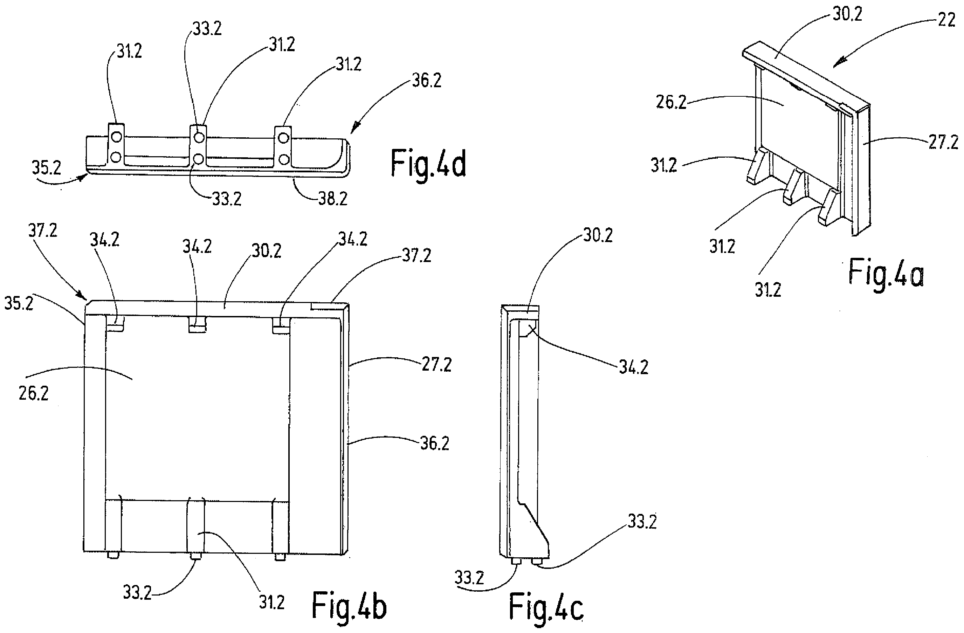

Eine zweite Sorte 22 Wandmodule (gesondert in den Figuren 4a bis 4c dargestellt) des Baukastensystems weist keine Druckentlastungsöffnung auf, gleicht der ersten Sorte 21 Wandmodule aber ansonsten, wenigstens hinsichtlich der äußeren Form und/oder der Abmessungen.

Zu der Anordnung 15 gemäß Figur 2a bis 2d gehört ein Exemplar der zweiten Sorte 22 Wandmodule. Ausführungsformen der Anordnung 15 bzw. des Gehäuses 10 sind möglich, welche genau zwei oder genau vier Exemplare der ersten Sorte 21 oder zweiten Sorten 22 Wandmodule aufweisen.

Die erste Sorte 21 Wandmodule gemäß Figuren 3a-3d weist einen ebenen ersten Wandabschnitt 26.1 auf. Das Wandmodul weist einen zweiten Wandabschnitt 27.1 auf, welcher zu dem ersten Wandabschnitt 26.1 abgewinkelt ist, beispielsweise senkrecht abgewinkelt. Der erste Wandabschnitt 26.1 und der zweite Wandabschnitt 27.1 stoßen gedacht an einer Kante an, welche eine vertikale Seitenkante 14a, 14b, 14c, 14d des Gehäuses 10 bildet. Gegenüberliegend weist die Wandmodule der ersten Sorte 21 keine Seitenkante 14a, 14b, 14c, 14d des Gehäuses auf. Diese ist vielmehr von einem weiteren Exemplar eines Wandmoduls derselben Sorte 21 oder der zweiten Sorte 22 beinhaltet, welches zu der Anordnung 15 gehört. Der erste Wandabschnitt 26.1 und der zweite Wandabschnitt 27.1 sind miteinander nahtlos einstückig verbunden. Die Gussform (Werkzeug) ist bevorzugt entsprechend ausgebildet, um die Wandmodule der ersten Sorte 21 mit dem ersten Wandabschnitt 26.1 und dem zweiten Wandabschnitt 27.1 zu erzeugen.

Das Wandmodul 21 der ersten Sorte Wandmodule weist einen Flanschabschnitt 30.1 auf. Der Flanschabschnitt 30.1 ist quer, beispielsweise senkrecht, zu dem ersten Wandabschnitt 26.1 und dem zweiten Wandabschnitt 27.1 abgewinkelt angeordnet. Der Flanschabschnitt 30.1 und der erste Wandabschnitt 26.1 und der zweite Wandabschnitt 27.1 sind miteinander nahtlos einstückig verbunden. Die Gussform ist entsprechend ausgebildet, um den ersten Wandabschnitt 26.1, den zweiten Wandabschnitt 27.1 und den Flanschabschnitt 30.1 aneinander angeformt zu erzeugen.

An dem ersten Wandabschnitt 26.1 sind Stabilisierungsfortsätze 31.1 angeformt. Die Stabilisierungsfortsätze 31.1 sind mit dem ersten Wandabschnitt 26.1 nahtlos einstückig beim Herstellen des Wandmoduls 21.1 durch Gießen verbunden. Diese Stabilisierungsfortsätze 31.1 in Form von Rippen erstrecken sich von dem ersten Wandabschnitt 26.1 weg, und zwar von der Innenseite 32.1 des ersten Wandabschnitts 26.1 weg, d.h. in der Anordnung 15 in den Innenraum 17 des Gehäuses 10. An jedem Stabilisierungsfortsatz 31.1 sind Vorsprünge 33.1 angeordnet. Die Vorsprünge 33.1 sind vorzugsweise an dem Stabilisierungsfortsatz 31.1 angeformt, besonders bevorzugt beim Gießen des Wandmoduls 21 geformt. Die Vorsprünge 33.1 können auch auf andere Art mit den Stabilisierungsfortsätzen 31.1 verbunden sein, beispielsweise durch eine Schweißverbindung oder eine Klebeverbindung. Ein Anformen der Vorsprünge 33.1 beim Gießen ist aber klar bevorzugt, da diese der lagerichtigen Anordnung der Wandmodule 16a-d relativ zueinander, relativ zu dem Bodenelement 16 und der Verbindung des Bodenelements 16 mit den Wandmodulen 16a-d dienen.

Der Flanschabschnitt 30.1 ist einerseits unmittelbar mit dem ersten Wandabschnitt 26.1 und andererseits mittelbar über weitere rippenartige Stabilisierungsfortsätze 34.1 mit dem ersten Wandabschnitt 26.1 verbunden. Die weiteren Stabilisierungsfortsätze 34.1 sind nahtlos einstückig mit dem ersten Wandabschnitt 26.1 und mit dem Flanschabschnitt 30.1 verbunden.

An dem ersten Wandabschnitt 26.1, an dem zweiten Wandabschnitt 27.1 und an dem Flanschabschnitt 30.1 sind Kantenabschnitte 35.1, 36.1, 37.1 dazu eingerichtet mit entsprechenden Kantenabschnitten eines angrenzenden Wandmoduls stoffschlüssig verbunden zu werden, insbesondere verschweißt zu werden. Die Kantenabschnitte 35.1, 36.1, 37.1 können beispielsweise, wie dargestellt, eine Fase aufweisen. Kantenabschnitt 38.1 des Wandelements 21 kann der Stoffschlussverbindung, insbesondere Schweißverbindung, mit der Bodenplatte 19 dienen.

Wie sich aus Figur 3c ergibt, ist das Druckentlastungselement 25.1 bevorzugt in das Wandmodul 21 eingegossen, um die Druckentlastungsöffnungen 24.1 zu verschlie-ßen. Durch das Eingießen entfällt ein nachträgliches Verbinden des Druckentlastungselements 25.1 mit dem Wandmodul 21. Das Druckentlastungselement 25.1 kann beispielsweise ein Gitter oder eine Gitteranordnung, beispielsweise ein gewebtes Gitter oder ein gelegtes Gitter oder beispielsweise ein Wirrfaserkörper sein.

Die zweite Sorte untereinander gleicher Wandmodule 22 gemäß Figuren 4a-4c unterscheidet sich von der ersten Sorte untereinander gleicher Wandmodule 21 gemäß Figur 3a-3c dadurch, dass keine Druckentlastungsöffnungen vorhanden sind. Ansonsten ist die Form, insbesondere die Abmessungen, der gegossenen weiteren Wandmodule gemäß der zweiten Sorte gleich. Zur Beschreibung der zweiten Sorte Wandmodule 22, insbesondere deren bevorzugt nahtlos einstückig miteinander verbundenen ersten Wandabschnitt 26.2, zweite Wandabschnitt 27.2, Flanschabschnitt 30.2, Stabilisierungsfortsätze 31.2, weitere Stabilisierungsfortsätze 34.2, Vorsprünge 33.2 kann daher ansonsten die Beschreibung der ersten Sorte 21 Wandmodule herangezogen werden.

Die dritte Sorte untereinander gleicher Wandmodule 23, welche in den Figuren 5a-5c gezeigt ist, ist bevorzugt nicht mit einem weiteren Wandmodul 23 der dritten Sorte über Eck zu verbinden. Seitenkanten 14a-d des Gehäuses 10 sind vielmehr bevorzugt ausschließlich dazu bestimmt, von einem Wandmodul 21 der ersten Sorte oder einem Wandmodul 22 der zweiten Sorte Wandmodule gebildet zu werden. Die Wandmodule erster Sorte 21 und zweiter Sorte 22 bilden diese mit zwei zueinander abgewinkelten Wandabschnitten 26.1 und 27.1 bzw. 26.2 und 27.2, welche an einer Seitenkante des Gehäuses gedacht zusammenstoßen, so dass die betreffende Seitenkante durch ein einziges Wandmodul 21 oder 22 gebildet ist. Wandmodule müssen auf diese Weise nicht über Eck schweiß- und/oder kleben verbunden werden, sondern können mittels Stumpfstoß miteinander verbunden werden.

Die dritte Sorte Wandmodule 23 unterscheidet sich von der ersten Sorte Wandmodule 21 in der Abmessung und dem Fehlen eines zweiten Wandabschnitts. Zur Beschreibung der dritten Sorte 23 Wandmodule kann ansonsten die Beschreibung zur ersten Sorte 21 Wandmodule herangezogen werden. Insbesondere kann die dritte Sorte 23 Druckentlastungsöffnungen 24.3 aufweisen, wie sich aus den Figuren 5a bis 5c beispielhaft ergibt. Der erste Wandabschnitt 26.3, die Stabilisierungsfortsätze 31.3, die weiteren Stabilisierungsfortsätze 34.3 sowie der Flanschabschnitt 30.3 sind vorzugsweise, beispielsweise so wie dargestellt, aneinander nahtlos einstückig angeformt. Die Vorsprünge 33.3 können an den Stabilisierungsfortsätzen 31.3 ebenfalls beim Gießen des Wandmoduls 23 angeformt sein. Alternativ können die Vorsprünge 31.3 nachträglich an den Stabilisierungsfortsätzen 31.3 befestigt worden sein.

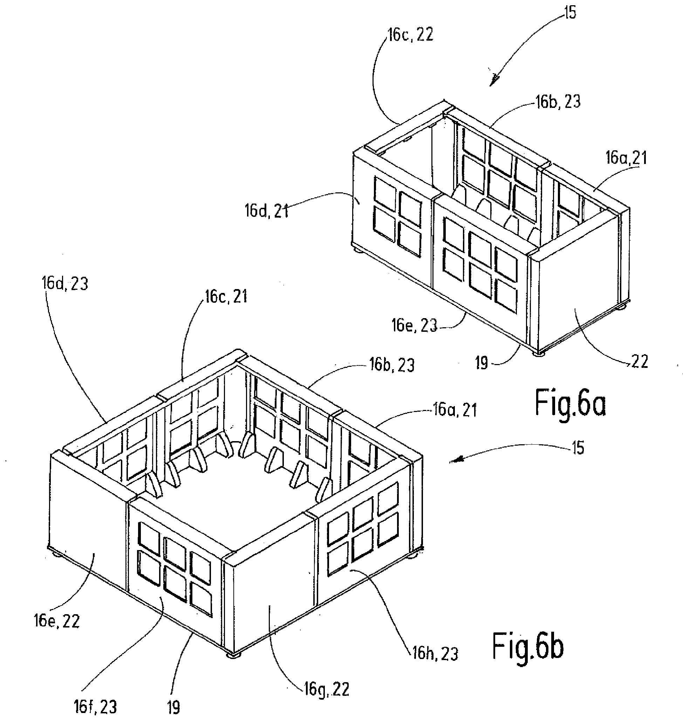

Mit dem Ausführungsbeispiel des erfindungsgemäßen Baukastensystems mit nur drei unterschiedlichen Wandmodulen 21, 22, 23 können unterschiedlich große Gehäuse 10 gefertigt werden, wie sich aus den Figuren 1a, 6a und 6b ergibt, die Anordnungen 15 von Wandmodulen zeigen. Ausführungsbeispiele des erfindungsgemäßen Baukastensystems mit nur zwei unterschiedlichen Sorten, z.B. erste Sorte 21 und zweite Sorte 22 oder erste Sorte 21 und dritte Sorte 23 oder zweite Sorte 22 und dritte Sorte 23, sind möglich.

Bei der Herstellung eines explosionsgeschützten Gehäuses 10, beispielsweise des Gehäuse 10 gemäß Figur 1, kann beispielsweise wie folgt vorgegangen werden:

Es werden, vorzugsweise gegossene, Wandmodule 16a-d bereitgestellt. Soll ein Gehäuse 10 gemäß Figur 1a gefertigt werden, werden zwei unterschiedliche Sorten 21, 22 Wandmodule benötigt, und zwar drei Wandmodule 21 der ersten Sorte, welche jeweils Druckentlastungsöffnungen 24.1 aufweisen und ein Wandmodul 22 der zweiten Sorte, welches dieselbe Größe hat, aber keine Druckentlastungsöffnungen aufweist. In ein oder mehrere Wandmodule können explosionssichere, insbesondere zünddurchschlagsichere, Leitungsdurchführungen eingebracht werden, insbesondere in solche ohne Druckentlastungsöffnung, um Komponenten im Innenraum 17 des Gehäuses 10, welche Zündquellen bilden können, elektrisch zu kontaktieren. Um einen Innenraum 17 des Gehäuses 10 in Umfangsrichtung mittels der vorzugsweise gegossenen Wandelemente 16a-d zu umschließen, werden die Wandmodule 16a-d werden zu einer quaderförmigen Anordnung von Seitenwänden arrangiert, und zwar so, dass die Zapfen 33.1, 33.2 durch Ausnehmungen 40 in der Platte 19 geführt sind, welche den Boden 12 des Gehäuses 10 bilden kann, wie sich aus Figur 2c ergibt. Die Wandmodule 16a-16d lassen sich so leicht lagerichtig relativ zu der Platte 19 und zueinander positionieren. Alternativ oder zusätzlich zu an den Wandmodulen 16a-d ausgebildeten Zapfen können entsprechende Zapfen an der Platte 19, welche den Boden oder eine Rückwand bilden kann, ausgebildet sein, welche in Ausnehmungen in den Wandmodulen 16a-d greifen. Auch mittels einer solchen Ausrichteinrichtung lassen sich die Wandmodule 16a-d einfach lagerichtig relativ zu der Platte 19 positionieren.

Die Platte 19 wird mit den Wandmodulen 16a-d mittels Lochschweißungen durch die Ausnehmungen 40 in der Platte 19 verbunden. Dabei wird eine Schweißverbindung, insbesondere zwischen der Platte 19 und den Zapfen 33.1, 33.1 hergestellt. Es kann erforderlich sein Spalte zwischen den Wandmodulen 16a-d und der Platte 19 mittels einer umlaufenden Schweiß- und/oder Klebenaht zu schließen also eine Dichtnaht auszubilden.

Die Wandmodule 16a-16d werden untereinander an den Stumpfstoßstellen durch Stumpfnähte, insbesondere Schweiß- und/oder Klebenähte verbunden. Diese sind vorzugsweise Dichtnähte, um nicht einen zünddurchschlagsicheren Spalt zwischen den angrenzenden Wandmodulen 16a-16d sicherstellen zu müssen. Dazu dienen die mit Fasen versehenen Kantenabschnitte 35.1, 35.2, 36.1, 36.2, 37.1, 37.2 der ersten Wandabschnitte 26.1, 26.2, der zweiten Wandabschnitte 27.1, 27.2 und der Flanschabschnitte 30.1, 30.2 der Wandmodule 16a bis 16d. Auf Grund der Fasen bilden die Kantenabschnitte 35.1, 35.2, 36.1, 36.2, 37.1, 37.2 zwischen angrenzenden Wandmodulen V-förmige Ausnehmungen zum Ausbilden der Stumpfnähte zum Verbinden der Wandmodule 16a-d.

Wie in den dargestellten Ausführungsbeispielen werden bevorzugt wenigstens zwei Wandmodule 16a-d nicht über eine oder an einer Seitenkante 14a-d des Gehäuses 10, d.h. gemeinsam, ggf. mit der Schweiß- und/oder Klebenaht, eine Seitenkante 14a-d bildend, aneinander befestigt. Vielmehr ist die Schweißnaht und/oder Klebenaht bevorzugt neben der Seitenkante 14a-d, insbesondere parallel zu der Seitenkante 14a-d, mit Abstand zu der Seitenkante 14a-d ausgebildet.

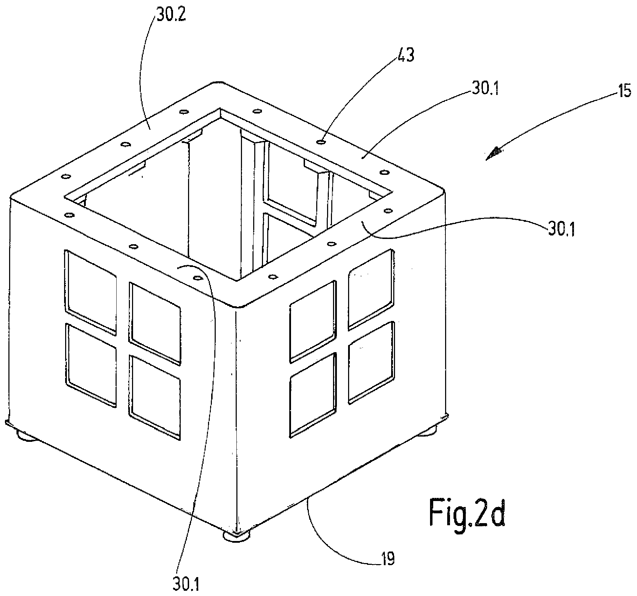

An der Bodenplatte 19 können an den Ecken Füße 41 befestigt werden, beispielsweise durch Schweißen (Figur 1c). Es wird eine Anordnung wie in Figur 2d gezeigt, erhalten. Die Schweißnähte sind in der Figur 2d nicht gesondert eingezeichnet. In Figur 1 ist Schweißnähten zwischen Wandmodulen und zwischen den Wandmodulen und der Bodenplatte 19 das Bezugszeichen 42 zugewiesen.

Um das Gehäuse 10 sicher verschließen zu können, wird der durch die in den gezeigten Ausführungsbeispielen wenigstens vier verbundenen Flanschabschnitte 30.1, 30.2 gebildete Flansch vorzugsweise plangefräst. Es können Gewindebohrungen 43 in den Flansch eingebracht werden oder es können andere Verbindungsmittel vorgesehen werden, um die Deckelplatte 20 mit dem Flansch zu verbinden, um das Gehäuse 10 zu schließen. Zwischen der Flanschfläche und der Deckelplatte 20 wird bevorzugt ein zünddurchschlagsicherer Flachspalt ausgebildet.

Die Gewindebohrungen 43 sind bevorzugt Sacklöcher, welche bis in die weiteren Stabilisierungsfortsätze 34.1, 34.2 reichen können, ohne jedoch in den Innenraum 17 des Gehäuses 10 durchzubrechen. Damit wird einerseits eine hohe Stabilität der Verbindung des Elements 20 zum Bilden des Gehäusedeckels 13 mit dem Flansch erreicht, um ein sicheres Verschließen des Gehäuses 10 zu ermöglichen, und andererseits vermieden, dass an dieser Stelle ein explosionssicherer Gewindespalt gebildet werden muss.

Mit dem erfindungsgemäßen Baukastensystem können unterschiedlich große Gehäuse 10 aus Guss- und/oder Umformteilen hergestellt werden, ohne für jede Größe des Gehäuses 10 eine eigene Gießform oder ein Umformwerkzeug bereitstellen zu müssen. Auch ist der Transport der einzelnen Wandmodule 16a-h zum Hersteller des Gehäuses 10 günstiger, als wenn ein gegossener Gehäusekörper transportiert werden muss, welcher beispielsweise vier Umfangsseiten 11a-d bildet. Die lagerichtige Anordnung und die Fixierung der Wandmodule 16a-h an einer Platte 19, beispielsweise einer Bodenplatte 19, ist besonders einfach, wenn Zapfen oder andere Vorsprünge 33.1, 33.2, 33.3 und entsprechende Ausnehmungen 40 in der Platte 19 für die Fixierung der Wandmodule 16a-h vorhanden sind. Die Herstellung eines Gehäuses 10 mit dem erfindungsgemäßen Baukastensystem wird besonders kostengünstig, wenn für den Gehäuseboden 12 und den Gehäusedeckel 13 Plattenmaterial (insbesondere handelsübliches genormtes Halbzeug) verwendet wird. Die Verbindung der einzelnen Wandmodule 16a-h untereinander und mit einem oder beiden plattenförmigen Elementen 19, 20 erfolgt bevorzugt stoffschlüssig, insbesondere durch Schweißen, Kleben oder beides in Kombination. Die Wandmodule 16a-h sind bevorzugt aus Metall, insbesondere Aluminium oder Stahl, oder Kunststoff. Alternativ zu gegossenen Wandmodulen 16a-h können umgeformte Blechteile als Wandmodule 16a-h verwendet werden oder aus umgeformten Blechteilen gebildete Wandmodule.

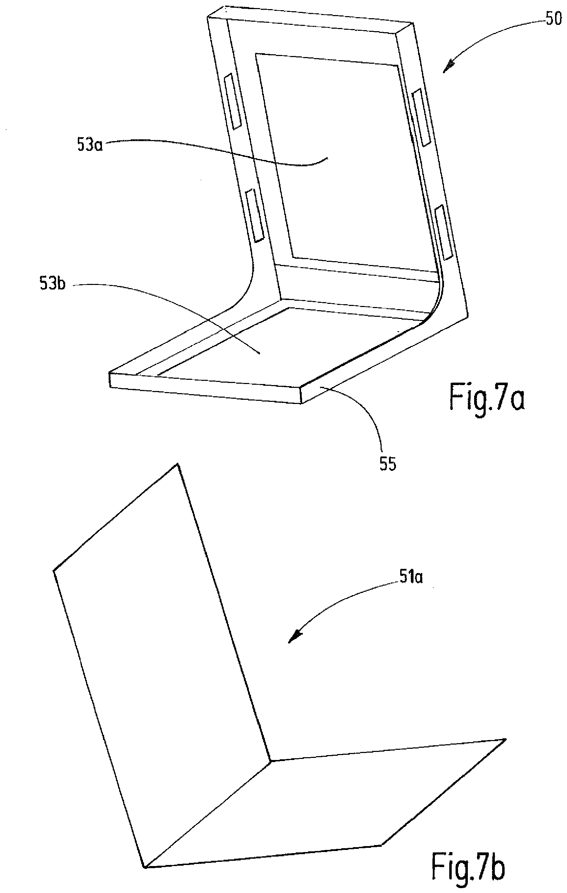

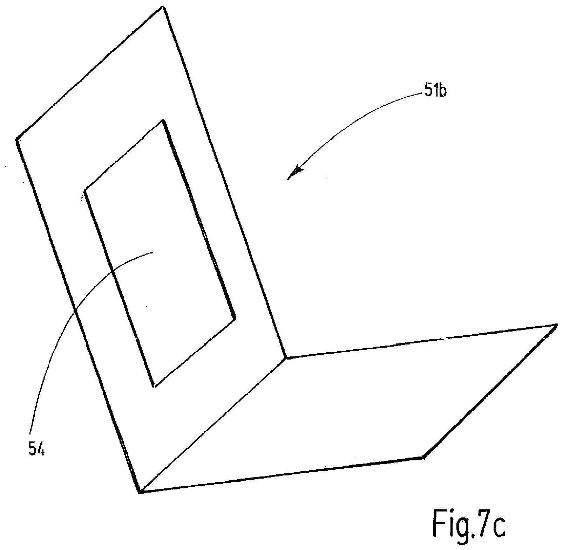

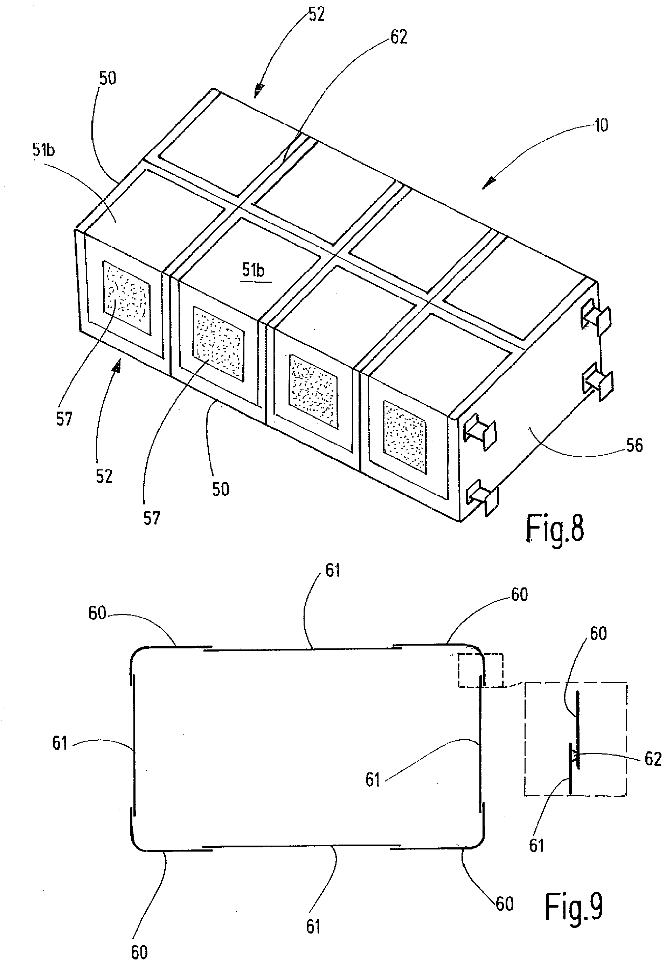

Figur 7a zeigt ein Ausführungsbeispiel eines Grundkörpers 50 als ein Modul eines erfindungsgemäßen Baukastensystems. Das Modul 50 kann zusammen mit einem Schließelement 51a, 51b ein Wandmodul 52 bilden. Figur 7b zeigt ein Beispiel eines solchen Schließelements 51a des Wandmoduls 52. Figur 7c zeigt ein weiteres Beispiel eines Schließelements 51b. Figur 8 zeigt eine perspektivische Ansicht auf den Rücken eines Gehäuses 10 aufgebaut aus Wandmodulen 52 des Typs zusammengesetzt aus dem Grundkörper 50 und Schließelementen 51a, 51b gemäß Figuren 7a, 7b, 7c. Das Wandmodul 52 ist ein Beispiel eines Wandmoduls, welches aus wenigstens einem gegossenen Grundkörper 50 und wenigstens einem Blechteil 51a, 51b hergestellt ist. Ein solcher Grundkörper 50 kann zur Gewichtsersparnis wenigstens eine Öffnung 53a, 53b aufweisen, die mittels des eines Schließelements 50a, 50b zünddurchschlagsicher verschließbar ist.

Der Grundkörper 50 weist eine winkel- oder L-förmige Gestalt auf. Alternativ kann der Grundkörper 50 flächig sein und ggf. einen Verbindungsansatz aufweisen. Einen Verbindungsansatz an einem flächigen Wandmodul bilden z.B. die Kantenabschnitte 35.1, 36.1, 37.1 der Ausführungsform gemäß Figuren 1 bis 6b. Es ist auch möglich einen U-förmigen Grundkörper vorzusehen.

Die Typen Schließelemente 50a, 50b zum Schließen der Öffnungen 53a, 53b können eine der Form des Grundkörpers 50 entsprechende Form, beispielsweise eine L-Form aufweisen. Alternativ können mehrere Öffnungen 53a, 53b durch jeweils ein flächiges Schließelement 50a, 50b zu schließen sein. Die Schließelemente 51a, 51b können außen an dem Grundkörper zu befestigen sein oder in dem Grundkörper anzuordnen sein. Weitere Ausführungsformen machen beides möglich. Das Schließelement 50a gemäß Figur 7b weist in dem Bereich zum Schließen der Öffnungen in dem Grundkörper keine Öffnungen auf. Das Schließelement 50b gemäß Figur 7c weist eine Druckentlastungsöffnung 54 auf, welche, wenn bei einem druckfest gekapselten Gehäuse 10 mit einem zünddurchschlagsicheren Druckentlastungskörper 54 zu verschließen ist.

Der Grundkörper 50 weist bevorzugt eine Ausrichtstruktur 55, beispielsweise eine Bohrung 55, auf, mittels welcher der Grundkörper 50 relativ zu einem benachbarten Grundkörper 50 ausgerichtet und/oder an diesem vorfixiert werden kann, z.B. über eine Schraubenverbindung, um die Anordnung der Module 50 auszurichten und anschließend die Ausrichtung beispielsweise mittels Schweiß- und/oder Klebeverbindungen zu fixieren. Wie Figur 8 veranschaulicht, sind die Wandmodule 52 in einer Erstreckungsrichtung, hier in Höhenrichtung, in Paaren aneinander gereiht angeordnet. Jedes Paar umschließt U-förmig einen Abschnitt des Gehäuseinnenraums in Erstreckungsrichtung. Durch Variieren der Anzahl an Paaren, die aneinander angeordnet werden, können unterschiedlich hohe Gehäuse 10 und damit Gehäuse 10 mit unterschiedlichen Innenvolumen hergestellt werden.

Die Module 50 eines Paares können an den Stoßflächen miteinander beispielsweise verschweißt und/oder verklebt werden. Die in Reihenrichtung aneinander angrenzenden Module 50 können an den Stoßflächen beispielsweise verschweißt und/oder verklebt werden. Die Schweiß- und/oder Klebenähte bilden Dichtnähte, so dass an den Stoßflächen kein zünddurchschlagsicherer Spalt, z.B. Flachspalt, sichergestellt werden muss. Auch die plattenförmigen Elemente 56, welche den Boden und die Oberseite des Gehäuses 10 bilden, sind bevorzugt mit Dichtnähten mit den angrenzenden Modulen 50 verbunden. Die Vorderseite des Gehäuses 10, auf welcher das Gehäuse 10 in Figur 8 liegend dargestellt ist, kann mit einem Schließelement zu schließen sein, wobei zwischen dem Schließelement und dem Gehäuse 10 ein zünddurchschlagsicherer Spalt ausgebildet wird. Wie aus Figur 8 hervorgeht, sind alle Grundkörper 50 der in der Ansicht vorderen Reihe mit Schließelementen 50b vom Typ gemäß Figur 7c geschlossen, wobei die Druckentlastungsöffnung in dem Schließelement 51b mit einem zünddurchschlagsicheren, gasdurchlässigen Druckentlastungselement 57 verschlossen ist. Das Druckentlastungselement 57 ist bevorzugt auf der Innenraumseite des Schließelements 51b angeordnet, um im Falle einer Explosion von Innen gegen das Schließelement 51b gedrückt zu werden. Es ist alternativ möglich mit einem Druckentlastungskörper 57 eine Öffnung in dem Grundköper 50 zu direkt zu schließen, ohne dazwischen ein Schließelement anzuordnen. Andere Grundkörper 50 des Gehäuses können mittels Schließelementen 50a des Typs gemäß Figur 7b geschlossen sein, wenn an der entsprechenden Stelle des Grundkörpers 50 kein Druckentlastungselement benötigt wird. Die Druckentlastungselemente 57 oder auch 25.1, 25.3 (s. Figur 1) können mittels eines Schutzelements (nicht dargestellt) vor Verschmutzung, insbesondere Verstopfung von Poren, durch Staub und/oder Feuchtigkeit geschützt sein, welches Schutzelement bei einer Explosion zerstört und/oder abgesprengt wird, um die fluidische Verbindung zwischen dem Innenraum 17 des Gehäuses 10 und der Umgebung durch die Druckentlastungselemente 57 oder 25.1, 25.3 hindurch freizugeben.

Figur 9 veranschaulicht ein erfindungsgemäßes Gehäuse 10, dessen Umfang aus Eckmodulen 60 und Flächenmodulen 61 aus Blech zusammengesetzt ist, die unter Ausbildung von Dichtnähten 62 verschweißt und/oder verklebt sind. Die Dichtnähte 62 sind jeweils parallel zur benachbarten runden Kante 63 des Gehäuses 10 ausgebildet. Ein Eckstoß, welcher die Kante bildet, wird damit vermieden, um eine besonders hohe Explosionsfestigkeit zu erzielen. Die Dichtnähte 62 verbinden benachbarte Module 60, 61 mittels Überlappstoß (s. Ausschnitt in Figur 9). Alternativ können benachbarte Module 60, 61 im Stumpfstoß miteinander verbunden sein.

Während in den Figuren quaderförmige Gehäuse 10 gezeigt sind, können Ausführungsformen erfindungsgemäßer Baukastensystem auch dazu geeignet sein, von der Quaderform abweichende Gehäuseformen herzustellen. Die Außenseiten aneinander angrenzender Wandmodule können in solchen Ausführungsformen beispielsweise einen Winkel von 90° einschlie-ßen, um beispielsweise ein L-förmiges oder U-förmiges Gehäuse herstellen zu können.

Das erfindungsgemäße Konzept eignet sich insbesondere für Module aus Stahl, Aluminium oder Kunststoff.

Es wird ein explosionsgeschütztes Gehäuse (10), bevorzugt der Schutzart druckfeste Kapselung, angegeben, wobei das Gehäuse 10 aus mehreren (wenigstens zwei) Wandmodulen (16a-h) eines Baukastensystems mit einem oder mehreren Modultypen zusammengesetzt ist.

**Bezugszeichenliste:**

| | |
|---|---|
| 10 | Gehäuse |
| 11a-d | Umfangsseiten(wände) |
| 12 | Boden |
| 13 | Deckel |
| 14a-d | Seitenkanten |
| 15 | Anordnung |
| 16a-h | Wandmodul |
| 17 | Innenraum |
| 19 | Element |
| 20 | Element |
| 21 | Exemplar einer ersten Sorte Wandmodule |
| 22 | Exemplar einer zweiten Sorte Wandmodule |
| 23 | Exemplar einer dritten Sorte Wandmodule |
| 24.1,24.3 | Druckentlastungsöffnung |
| 25.1,25.3 | Druckentlastungselement |
| 26.1, 26.2, 26.3 | Erster Wandabschnitt |
| 27.1,27.2 | Zweiter Wandabschnitt |
| 30.1, 30.2, 30.3 | Flanschabschnitt |
| 31.1, 31.2, 31.3 | Stabilisierungsfortsätze |
| 32.1, 32.2, 32.3 | Innenseite |
| 33.1, 33.2, | Vorsprung |
| 33.3 | |
| 34.1, 34.2, 34.3 | Weitere Stabilisierungsfortsätze |
| 35.1, 35.2, 35.3, | Kantenabschnitt |
| 36.1, 36.2, 36.3 | Kantenabschnitt |
| 37.1, 37.2. 37.3 | Kantenabschnitt |
| 38.1, 38.2, 38.3 | Kantenabschnitt |
| 40 | Ausnehmung |
| 41 | Fuß |
| 42 | Schweißnaht |
| 43 | Gewindebohrung |
| 50 | Grundkörper |
| 51a | Schließelement |
| 51b | Schließelement |
| 52 | Wandmodul |
| 53a | Öffnung |
| 53b | Öffnung |
| 54 | Druckentlastungsöffnung |
| 55 | Ausrichtstruktur/Bohrung |
| 56 | Plattenförmiges Element |
| 57 | Druckentlastungselement |
| 60 | Eckmodul |
| 61 | Flächenmodul |
| 62 | Dichtnaht |
| 63 | Kante |

## Patentansprüche

1. Wandmodul (16a-h) für ein explosionsgeschütztes Gehäuse (10), **dadurch gekennzeichnet , dass** das Wandmodul (16a-h) aufweist:
- wenigstens einen Vorsprung (33.1, 33.2, 33.3) zur lagerichtigen Anordnung eines beispielsweise plattenförmigen Elements (19, 20), relativ zu dem Wandmodul (16a-h), welche in eine Ausnehmung (40) in dem Element (19, 20) eingreifen, und
- einen oder mehrere Stabilisierungsfortsätze (31.1, 31.2, 31.3, 34.1, 34.2, 34.3), welcher/welche sich von dem Wandmodul (16a-h) weg erstreckt.

2. Explosionsgeschütztes Gehäuse (10), bevorzugt der Schutzart druckfeste Kapselung, wobei das Gehäuse (10) wenigstens ein Wandmodul (16a-h) eines Baukastensystems zur Herstellung des Gehäuses (10) aufweist, wobei das Gehäuse (10) mehrere Wandmodule (16a-h) nach Anspruch 1 aufweist.

3. Gehäuse (10) nach Anspruch 2, wobei die Wandmodule (16a-h) gegossene Wandmodule sind oder wobei die Wandmodule (16a-h) aus Blech gefertigt sind.

4. Gehäuse (10) nach einem der vorstehenden Ansprüche 2 oder 3, wobei wenigstens ein Wandmodul (16a-h) eine Druckentlastungsöffnung (24, 24.1, 24.3) aufweist.

5. Gehäuse (10) nach Anspruch 4, wobei in ein Wandmodul (16a-h) mit einer Druckentlastungsöffnung (24, 24.1, 24.3) ein Druckentlastungselement (25, 25.1, 25.3) eingegossen ist.

6. Gehäuse (10) nach einem der vorstehenden Ansprüche 2-5, wobei wenigstens eine Seite des Gehäuses (10) mit einem bevorzugt plattenförmigen Element (19, 20) geschlossen ist.

7. Gehäuse (10) nach einem der vorstehenden Ansprüche 2-6, wobei die Wandmodule (16a-h) mit einem bevorzugt plattenförmigen Element (19, 20) einen zünddurchschlagsicheren Spalt, insbesondere einen Flachspalt, bilden.

8. Gehäuse (10) nach einem der vorstehenden Ansprüche 2-7, wobei der wenigstens eine Vorsprung (33.1, 33.2, 33.3) an einem Stabilisierungsfortsatz (31.1, 31.2, 31.3, 34.1, 34.2, 34.3) ausgebildet ist.

9. Gehäuse (10) nach einem der vorstehenden Ansprüche 2-8, wobei der wenigstens eine Vorsprung (33.1, 33.2, 33.3) mit dem Rand der Ausnehmung (40) schweißverbunden ist.

10. Gehäuse (10) nach einem der vorstehenden Ansprüche wobei die Wandmodule (16a-h) untereinander stoffschlüssig verbunden sind.

11. Gehäuse (10) nach einem der vorstehenden Ansprüche 2-10, wobei Wandmodule (16a-h) je einen Flanschabschnitt (30.1, 30.2, 30.3) zur Befestigung eines Elements (19, 20), insbesondere plattenförmigen Elements, bilden, wobei die Anordnung der Flanschabschnitte (30.1, 30.2, 30.3) nach dem Verbinden der Wandmodule (16a-h) bearbeitet ist, um einen Flachspalt zwischen den Flanschabschnitten (30.1, 30.2, 30.3) und dem Element (19, 20), insbesondere plattenförmigen Element, auszubilden.

12. Gehäuse (10) nach einem der vorstehenden Ansprüche 2-11, wobei Seitenkanten (14a-d) des Gehäuses (10) von Wandmodulen (16a-d) beinhaltet sind.

13. Baukastensystem zur Herstellung eines Gehäuses (10) nach einem der vorstehenden Ansprüche 2 bis 12 umfassend wenigstens einer Sorte, vorzugsweise gegossener, Wandmodule (21, 22, 23) nach Anspruch 1.

14. Verfahren zum Herstellen eines explosionsgeschützten Gehäuses (10) nach einem der vorstehenden Ansprüche 2 bis 12 mit den Schritten:
- Bereitstellen von, vorzugsweise gegossenen, Modulen, insbesondere Wandmodulen (16a-h) nach Anspruch
- Zusammensetzen des Gehäuses (10) aus den Modulen (16a-h) .

15. Verfahren nach Anspruch 14, wobei das Verfahren aufweist, Anordnen der Module, insbesondere Wandmodule (16a-h), zu dem Gehäuse oder einer Teilstruktur des Gehäuses, Ausrichten des Gehäuses oder der Teilstruktur und Fixieren der Ausrichtung.

## Claims

1. Wall module (16a-h) for an explosion-proof housing (10), **characterized in that** the wall module (16a-h) comprises
- at least one projection (33.1, 33.2, 33.3) for the positionally correct arrangement of an, for example plate shaped, element (19, 20) relative to the wall module (16ah), which engages in a recess (40) in the element (19, 20), and
- one or more stabilizing extensions (31.1, 31.2, 33.3, 34.1, 34.2, 34.3) extending away from the wall module (16a-h).

2. Explosion-proof housing (10), preferably of the protection type of flameproof enclosure, wherein the housing (10) comprises at least one wall module (16a-h) of a modular system for producing the housing (10), the housing (10) comprising a plurality of wall modules (16a-h) according to claim 1.

3. Housing (10) according to claim 2, wherein the wall modules (16a-h) are cast wall modules or wherein the wall modules (16ah) are made of sheet metal.

4. Housing (10) according to one of the preceding claims 2 or 3, wherein at least one wall module (16a-h) has a pressure relief opening (24, 24.1, 24.3).

5. Housing (10) according to claim 4, wherein a pressure relief element (25, 25.1, 25.3) is cast into a wall module (16a-h) with a pressure relief opening (24, 24.1, 24.3).

6. Housing (10) according to one of the preceding claims 2-5, wherein at least one side of the housing is closed with a preferably plate-shaped element (19, 20).

7. Housing (10) according to one of the preceding claims 2-6, wherein the wall modules (16a-h) form a flameproof gap, in particular a flat gap, with a preferably plate-shaped element (19, 20).

8. Housing (10) according to one of the preceding claims 2-7, wherein the at least one projection (33.1, 33.2, 33.3) is formed on a stabilizing extension (31.1, 31.2, 31.3, 34.1, 34.2, 34.3).

9. Housing (10) according to one of the preceding claims 2-8, wherein at least one projection (33.1, 33.2, 33.3) is welded to the edge of the recess (40).

10. Housing (10) according to one of the preceding claims 2-9, wherein the wall module (16a-h) is connected to one another by a material connection.

11. Housing (10) according to one of the preceding claims 2-10, wherein wall modules (16a-h) each form a flange section (30.1, 30.2, 30.3) for fastening an element (19, 20), in particular a plate-shaped element, wherein the arrangement of the flange sections (30.1, 30.2, 30.3) is processed after connecting the wall module (16a-h), in order to form a flat gap between the flange sections (30.1, 30.2, 30.3) and the element (19, 20), in particular a plate-shaped element.

12. Housing (10) according to one of the preceding claims 2-11, wherein side edges (14a-d) of the housing (10) are included by wall modules (16a-d).

13. Modular system for producing a housing (10) according to one of the preceding claims 2-12, comprising at least one type, preferably cast, wall modules (21, 22, 23) according to claim 1.

14. Method for producing an explosion-proof housing 10 according to one of the preceding claims 2-12 with the steps:
- Providing, preferably cast, modules, in particular wall modules (16a-h) according to claim 1,
- Assembling the housing (10) from the modules (16a-h).

15. Method according to claim 14, wherein the method comprises arranging the modules, in particular wall modules (16a-h), to the housing or a partial structure of the housing, aligning the housing or the partial structure and fixing the alignment.

## Revendications

1. Module mural (16a-h) destiné à un boîtier antidéflagrant (10), **caractérisé en ce que** le module mural (16a-h) présente :
- au moins une saillie (33.1, 33.2, 33.3) pour disposer dans la position correcte un élément (19, 20), par exemple en forme de plaque, par rapport au module mural (16a-h), qui s'engagent dans un évidement (40) de l'élément (19, 20), et
- une ou plusieurs protubérances de stabilisation (31.1, 31.2, 31.3, 34.1, 34.2, 34.2) qui s'étend(ent) à partir du module mural (16a-h).

2. Boîtier antidéflagrant (10), de préférence du type de protection à blindage résistant à la pression, dans lequel le boîtier (10) présente au moins un module mural (16a-h) d'un système modulaire destiné à la réalisation du boîtier (10), le boîtier (10) comportant plusieurs modules muraux (16a-h) selon la revendication 1.

3. Boîtier (10) selon la revendication 2, dans lequel les modules muraux (16a-h) sont des modules muraux moulés, ou dans lequel les modules muraux (16a-h) sont réalisés en tôle.

4. Boîtier (10) selon l'une des revendications précédentes 2 ou 3, dans lequel au moins un module mural (16a-h) présente un orifice de décompression (24, 24.1, 24.3).

5. Boîtier (10) selon la revendication 4, dans lequel un élément de décompression (25, 25.1, 25.3) est moulé dans un module mural (16a-h) doté d'une ouverture de décompression (24, 24.1, 24.3).

6. Boîtier (10) selon l'une des revendications précédentes 2 à 5, dans lequel au moins un côté du boîtier (10) est fermé par un élément (19, 20), de préférence en forme de plaque.

7. Boîtier (10) selon l'une des revendications précédentes 2 à 6, dans lequel les modules muraux (16a-h) forment un joint antidéflagrant, de préférence un joint plat, avec un élément (19, 20), de préférence en forme de plaque.

8. Boîtier (10) selon l'une des revendications précédentes 2 à 7, dans lequel la saillie (33.1, 33.2, 33.3), au nombre d'au moins une, est réalisée sur une protubérance de stabilisation (31.1, 31.2, 31.3, 34.1, 34.2, 34.2).

9. Boîtier (10) selon l'une des revendications précédentes 2 à 8, dans lequel la saillie (33.1, 33.2, 33.3), au nombre d'au moins une, est reliée par soudage au bord de l'évidement (40).

10. Boîtier (10) selon l'une des revendications précédentes 2 à 9, dans lequel les modules muraux (16a-h) sont reliés entre eux par matière.

11. Boîtier (10) selon l'une des revendications précédentes 2 à 10, dans lequel des modules muraux (16a-h) forment respectivement une partie formant bride (30.1, 30.2, 30.3) destinée à la fixation d'un élément (19, 20), notamment d'un élément en forme de plaque, l'arrangement des parties formant brides (30.1, 30.2, 30.3) étant traité après l'assemblage des modules muraux (16a-h), afin de créer un joint plat entre les parties formant brides (30.1, 30.2, 30.3) et l'élément (19, 20), notamment en forme de plaque.

12. Boîtier (10) selon l'une des revendications précédentes 2 à 11, dans lequel des bords latéraux (14a-d) du boîtier (10) sont contenus dans des modules muraux (16a-h).

13. Système modulaire destiné à la réalisation d'un boîtier (10) selon l'une des revendications précédentes 2 à 12, comprenant au moins un type de modules muraux (21, 22, 23) moulés selon la revendication 1.

14. Procédé de réalisation d'un boîtier antidéflagrant (10) selon l'une des revendications précédentes 2 à 12, comprenant les étapes suivantes :
- mise à disposition de modules, notamment de modules muraux (16ah), de préférence moulés, selon la revendication 1,
- assemblage du boîtier (10) à partir des modules (16a-h).

15. Procédé selon la revendication 14, le procédé présentant la mise en place des modules, notamment des modules muraux (16a-h), pour réaliser le boîtier ou une structure élémentaire du boîtier, positionnement du boîtier ou de la structure élémentaire, et fixation du positionnement.
